Europäisches Patentamt

European Patent Office

Office européen des brevets

(11) Publication number: **0 346 901**
**A2**

## (12) EUROPEAN PATENT APPLICATION

(21) Application number: **89110889.6**

(22) Date of filing: **15.06.89**

(51) Int. Cl.⁴: **H01L 31/10 , H01L 31/08**

(30) Priority: **17.06.88 JP 149732/88**

(43) Date of publication of application:
**20.12.89 Bulletin 89/51**

(84) Designated Contracting States:
**DE FR GB**

(71) Applicant: **HAMAMATSU PHOTONICS K.K.**
**1126-1 Ichino-cho Hamamatsu-shi**
**Shizuoka-ken(JP)**

(72) Inventor: **Mizushima, Yoshihiko c/o**
**HAMAMATSU PHOTONICS K.K.**
**No. 1126-1, Ichino-cho**
**Hamamatsu-shi Shizuoka(JP)**
Inventor: **Nakajima, Kazutoshi c/o**
**HAMAMATSU PHOTONICS K.K.**
**No. 1126-1, Ichino-cho**
**Hamamatsu-shi Shizuoka(JP)**
Inventor: **Hirohata, Toru c/o HAMAMATSU**
**PHOTONICS K.K.**
**No. 1126-1, Ichino-cho**

**Hamamatsu-shi Shizuoka(JP)**
Inventor: **Iida, Takashi c/o HAMAMATSU**
**PHOTONICS K.K.**
**No. 1126-1, Ichino-cho**
**Hamamatsu-shi Shizuoka(JP)**
Inventor: **Warashina, Yoshihisa c/o**
**HAMAMATSU PHOTONICS K.K.**
**No. 1126-1, Ichino-cho**
**Hamamatsu-shi Shizuoka(JP)**
Inventor: **Sugimoto, Kenichi c/o HAMAMATSU**
**PHOTONICS K.K.**
**No. 1126-1, Ichino-cho**
**Hamamatsu-shi Shizuoka(JP)**
Inventor: **Kan, Hirofumi c/o HAMAMATSU**
**PHOTONICS K.K.**
**No. 1126-1, Ichino-cho**
**Hamamatsu-shi Shizuoka(JP)**

(74) Representative: **Patentanwälte Grünecker,**
**Kinkeldey, Stockmair & Partner**
**Maximilianstrasse 58**
**D-8000 München 22(DE)**

(54) **Semiconductor photodetector.**

(57) A semiconductor photodetector has a simple structure consisting of a semiconductor substrate, first and second Schottky electrodes formed on the substrate with a predetermined distance therebetween. A substrate surface between the first and second Schottky electrodes is made a light-receiving surface. An internal amplification function can be realized with a low bias voltage, by determining the distance between the Schottky electrodes so that an internal amplification factor G ( = $\tau/t$ ) becomes not less than 1.0, where $\tau$ and t represent a carrier lifetime and a carrier traveling time between the Schottky electrodes. The photodetector is applicable to detection of extremely weak light by virtue of its very small dark current.

FIG. 1

# SEMICONDUCTOR PHOTODETECTOR

## BACKGROUND OF THE INVENTION

The present invention relates to a semiconductor photodetector for converting input light into an electric signal.

Conventionally, there are known semiconductor photodetectors such as a pin photodiode, phototransistor, avalanche photodiode and photoconductive device. These devices are disclosed in, for example, Japanese Patent Application Unexamined Publication Nos. 213275/1987, 209852/1987 and 209853/1987.

The pin photodiode has a three-layer structure consisting of p-type, i-type and n-type semiconductors, and is equipped with a pair of ohmic electrodes on the both surfaces. With this structure, electron-hole pairs, i.e., carriers which have been produced by incident light are detected through the pn junction which is reversely biased.

The phototransistor has a structure of, for example, an n-p-n transistor. Electron-hole pairs are produced by incident light, and an output signal is produced in accordance with transistor amplification of an input optical signal.

The avalanche photodiode utilizes the well-known avalanche effect to obtain an avalanche-amplified output under the condition of high bias voltage.

The photoconductive device has a structure consisting of a semiconductor layer and a pair of ohmic electrodes formed thereon. An optical signal can be detected utilizing the change of resistivity in the semiconductor layer.

However, the conventional semiconductor photodetectors described above have following disadvantages.

While the pin photodiode is simple in structure, it is accompanied with a problem of large dark current which may cause noises. This means that the pin photodiode is not suitable for the detection of a weak optical signal. Furthermore, since the pin photodiode does not have an internal amplification function, it is difficult to obtain a sufficiently large output signal. On the contrary, although the phototransistor has the internal amplification function as a transistor and therefore can produce a large output signal in response to input light, it is complicated in structure because of its transistor nature. The phototransistor also has a problem that the influence of dark current is not negligible, which becomes a cause of noises.

On the other hand, although the avalanche photodiode can realize the internal amplification function based on the avalanche amplification, it needs a high bias voltage. Since it is not easy to produce the structure which can realize the avalanche amplification, the device is costly. Furthermore, it suffers from the noise-generating large dark current, and therefore is not applicable to the detection of the weak optical signal. On the contrary, the photoconductive device can realize the internal amplification function based on the photoconductive amplification at a relatively low bias voltage, and has a simple structure.

## SUMMARY OF THE INVENTION

Accordingly, an object of the present invention is to provide a semiconductor photodetector which is simple in structure, has low dark current, can be associated with an internal amplification function when necessitated, and can be driven by a low bias voltage.

A semiconductor photodetector according to the invention comprises: a semiconductor substrate; a first Schottky electrode formed on the semiconductor substrate; a second Schottky electrode formed on the semiconductor electrode so as to produce a predetermined distance from the first Schottky electrode; wherein a surface area of the semiconductor substrate between the first and second electrode is made a light-receiving surface, and a prescribed bias voltage is applied between the first and second Schottky electrodes.

The distance between the first and second Schottky electrodes may be determined so that an internal amplification factor, $G = \tau/t$, becomes not less than 1.0, where $\tau$ and $t$ represent a lifetime of carriers in the semiconductor substrate and a traveling time of carriers between the first and second Schottky electrodes, respectively.

While the semiconductor photodetector of the invention has a simple structure in which a pair of Schottky electrodes are formed on the semiconductor substrate, an optical signal incident on the area between the electrodes can be detected through conversion into an electric signal, and furthermore there occurs almost no dark current. If the distance between the Schottky electrodes are formed so that the internal amplification factor G becomes not less than 1.0, a sufficient internal amplification function can be obtained under a low bias voltage.

Other and further objects, features and advantages of the invention will appear more fully from the following description taken in connection with the accompanying drawings.

## BRIEF DESCRIPTION OF THE DRAWINGS

Fig. 1 is a perspective view of a semiconductor photodetector according to an embodiment of the present invention;

Fig. 2 is a graph showing a radiation sensitivity characteristic of the semiconductor photodetector of Fig. 1;

Fig. 3 is a cross-sectional view of the semiconductor photodetector of Fig. 1; and

Fig. 4 is a plan view of a semiconductor photodetector according to a modification of the invention.

## DESCRIPTION OF THE PREFERRED EMBODIMENTS

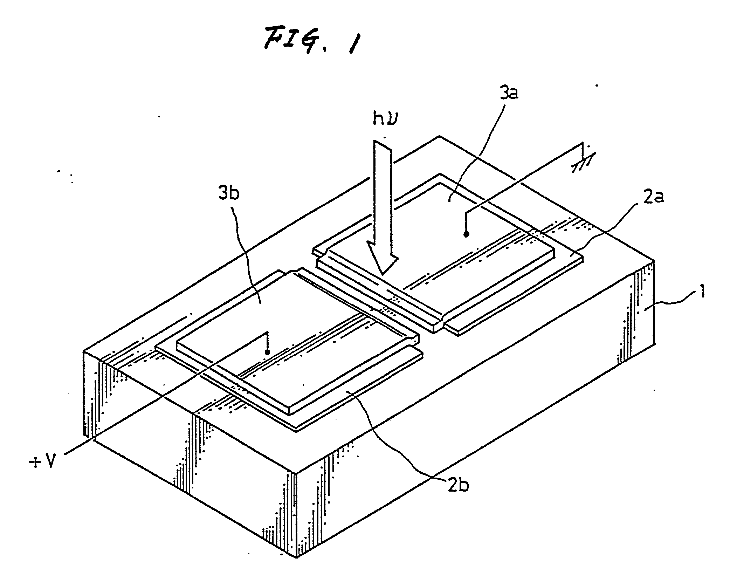

Preferred embodiments of the present invention will be described with reference to Figs. 1 to 4.

Fig. 1 is a perspective view showing a novel semiconductor photodetector according to an embodiment of the invention. In this figure, insulator films 2a and 2b of, e.g., SiO₂ are formed on a semiconductor substrate 1 of, e.g., n-type GaAs. A first Schottky electrode 3a and a second Schottky electrode 3b are formed on the insulator films 2a and 2b, respectively. End portions of the Schottky electrodes 3a and 3b are directly placed on a surface of the semiconductor substrate 1 so as to form respective Schottky junctions. A surface area of the semiconductor substrate 1 between the first and second Schottky electrodes 3a and 3b operates as a light-receiving surface on which an optical signal (hν) is made incident. Although various contact metals can be used as a Schottky electrode metal, titanium or tungsten silicide is most favorable.

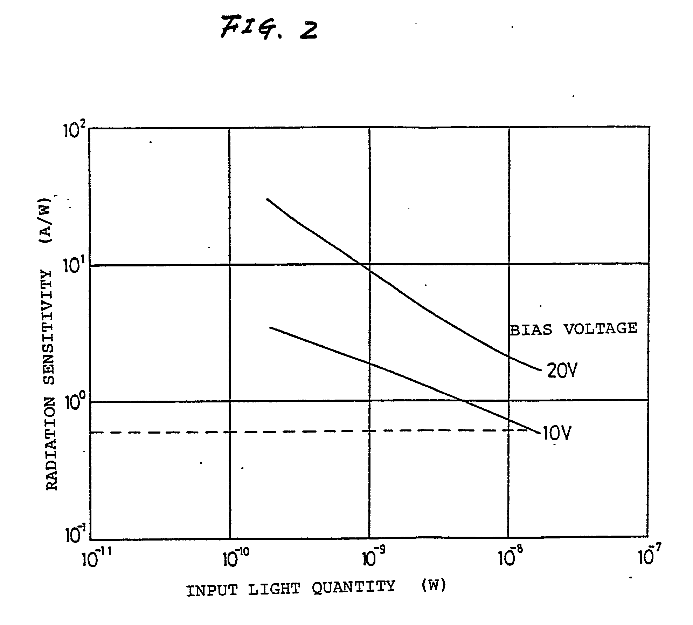

Fig. 2 shows an example of a radiation sensitivity characteristic, i.e., sensitivity of photoelectric conversion vs. incident light quantity, of a semiconductor photodetector having the structure of Fig. 1. More specifically, the distance between the first and second Schottky electrodes 3a and 3b was selected to be about 5 μm, and a bias voltage, typically 10 V and less than 20 V, was applied between the electrodes 3a and 3b. It is a feature of the invention that a high gain can be attained with such a low bias voltage.

The above-described semiconductor photodetector has the new structure and radiation sensitivity characteristics, which were first devised or found by the present inventors, and has following first to fourth advantages.

The first advantage is its very simple structure, in which as a basic structure a pair of Schottky electrodes 3a and 3b are formed on the semiconductor substrate 1, and just a DC bias voltage is applied to the pair of Schottky electrodes 3a and 3b. The insulator films 2a and 2b are not essential in the invention because these films merely work to restrict the Schottky junctions to small areas and, on the other hand, to extend the Schottky electrode surfaces to large areas. Further reduction of the dark current can be attained by making the Schottky junctions smaller. The larger surface areas of the Schottky electrodes 3a and 3b make easier the electrode connection or wire-bonding for providing the bias voltage.

Moreover, it is not necessary at all to fabricate pn junctions on the semiconductor substrate 1. In the case of the GaAs substrate, usually the substrate 1 is prepared by doping Cr which produces deep energy levels, or by making EL² compensation. Therefore the resistivity becomes higher, resulting in the smaller dark current. The conduction-type of the semiconductor is not restricted specifically.

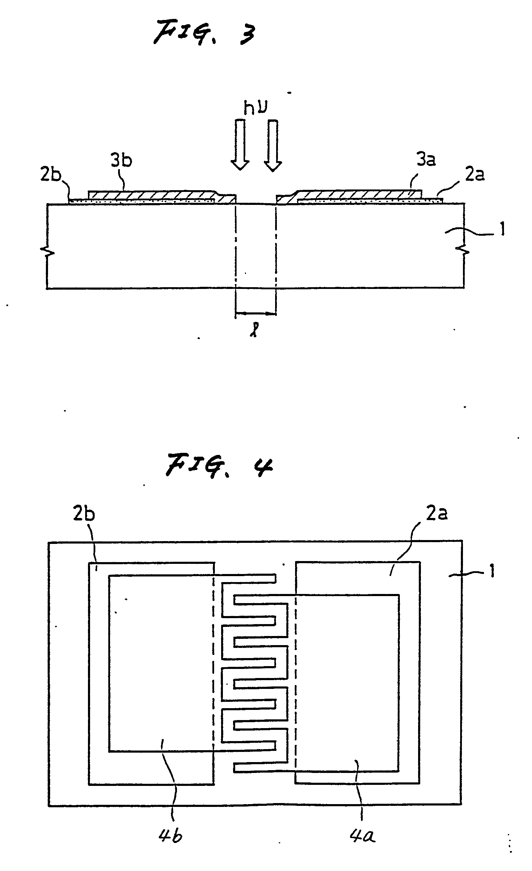

Although in the above measurement of the characteristic of Fig. 2 the distance between the first Schottky electrode 3a and the second Schottky electrode 3b was selected to be 5 μm, the distance is not limited to this value. The distance $l$ between the electrodes 3a and 3b, which is shown in Fig. 3, is determined as follows. The amplification factor G, which is an essential factor in considering the internal amplification function due to the photoconductive amplification, is expressed as:

$$G = \tau/t \qquad (1)$$

where $\tau$ means a lifetime of carriers in the semiconductor substrate 1 and t means a traveling time of carriers between a pair of Schottky electrodes 3a and 3b. While the lifetime $\tau$ is a constant which is determined by physical properties of the semiconductor substrate 1 and the type of carriers, etc., the traveling time t mainly depends on the distance $l$ between the electrodes and the bias voltage if the carrier type, etc. are fixed. For example, in order to obtain an amplification factor of 3.0, first the traveling time t is calculated using the equation (1) and then the distance $l$ is determined so as to obtain G = 3.0 with respect to the given bias voltage.

The second advantage of the invention is that the radiation sensitivity can be made extremely high. The internal amplification function of the invention is an entirely novel one. That is, the internal amplification function has been known in photoconductive devices, but it has not been known in devices of current-injection-prohibiting type such as the bi-directional Schottky type.

As shown in Fig. 2 by the dashed line, radiation sensitivity of 0.8 (A/W) is obtained with the 100% quantum efficiency. Fig. 2 also shows that the radiation sensitivity can be readily made more than 1.0 (A/W). Since the radiation sensitivity becomes higher in the range of low incident light quantity, the photodetector of the invention can detect extremely weak input light.

The third advantage of the present invention is that the above-described internal amplification function can be realized with the low bias voltage and the amplification factor G can be changed by the bias voltage. As shown in Fig. 2, even a bias voltage of 10 V can provide the internal amplification function. No conventional photodiode cannot realize the internal amplification function with such a low bias voltage. Furthermore, as shown in Fig. 2, the radiation sensitivity curves obtained with the bias voltages of 10 V and 20 V indicate a characteristic which has not been generally obtained in conventional semiconductor photodetectors. As described above, in the invention, since the photodetector can operate with the low bias voltage and the radiation sensitivity can be easily changed by the bias voltage, the photodetector can be readily combined with other semiconductor devices and also the radiation sensitivity can be adjusted very easily.

The fourth advantage of the present invention is that the dark current, which might be a cause of noises, can be made extremely small. For a typical structure of the invention, the dark current is less than 100 pA with a bias voltage of 10 V. Although conventional photoconductive devices can realize the internal amplification function, they cannot be applied to the detection of weak optical signals because of their large dark currents. On the other hand, since the photodetector of the invention can realize the internal amplification function with the small dark current, it can be applied to detection of extremely weak input optical signals.

Because the smallest detectable signal value is determined by the shot noise which is proportional to the dark current, the semiconductor photodetector of the invention can be used in the range approximately down to the input optical signal value corresponding to the output current which is equivalent to the dark current. This input optical signal value is dependent on the frequency range, that is, continuation time of detection, but is uniquely determined under the specific condition. Therefore, the semiconductor photodetector of the invention is most effective in this low input optical signal level and hence it is desirable that the device is so designed that the weak light of the above-described level is inputted to the device. More specifically, it is desirable to employ a filter for attenuating the input light, if the input light is too strong. This is also favorable in obtaining the maximum S/N ratio, in removing stray light, and in preventing the undesired drift phenomenon, etc. of the dark current.

Hereinafter, a modification of the above embodiment will be described.

Fig. 4 is a plan view of a semiconductor photodetector according to a modification of the present invention. This photodetector is different from the photodetector of Fig. 1 in that the first Schottky electrode 4a and the second Schottky electrode 4b have an interdigital shape in the Schottky junction areas and, as a result, the light-receiving surface is zigzaged. According to this modification, while the effective area of the light-receiving surface is widened, the distance between a pair of Schottky electrodes 4a and 4b can be maintained at a constant value. It is understood that, with this modification, both the receiving efficiency of the input optical signal and the detection sensitivity are made higher.

As described above, the semiconductor photodetector of the invention has such a simple structure that a pair of Schottky electrodes are formed on the semiconductor substrate, can convert the input optical signal being incident between these electrodes into the electric signal, and produces just a slightest amount of the dark current. If the distance of the Schottky electrodes are determined so that the internal amplification factor G ( $= \tau/t$ ) becomes not less that 1.0, the internal amplification function can be realized with the low bias voltage. Consequently, the present invention can provide the semiconductor photodetector which has the simple structure, can restrict the dark current to a very low value, can obtain the internal amplification function, and can be driven by the low bias voltage.

## Claims

1. A semiconductor photodetector, comprising:
a GaAs semiconductor substrate doped with compensating dopant;
a first Schottky electrode utilizing titanium or tungsten as a contact material and formed on said semiconductor substrate; and
a second Schottky electrode utilizing titanium or tungsten as a contact material and formed on said semiconductor substrate so as to produce a predetermined distance from said first Schottky electrode;
a surface area of said semiconductor substrate between said first and second Schottky electrodes being made a light-receiving surface, and a prescribed bias voltage being applied between said first and second Schottky electrodes.

2. A semiconductor photodetector as claimed in Claim 1, wherein said semiconductor substrate comprises a substrate material, and a crystal-grown semiconductor layer formed on said substrate material.

3. A semiconductor photodetector as claimed in Claim 1, wherein said distance between said first and second Schottky electrodes has been determined so that an internal amplification factor, $G = \tau/t$, becomes not less than 1.0, where $\tau$ and $t$ represent a lifetime of carriers in said semiconductor substrate and a traveling time of carriers between said first and second Schottky electrodes, respectively.

4. A semiconductor photodetector as claimed in Claim 3, wherein said bias voltage is about 10 volts.

5. A semiconductor photodetector as claimed in Claim 1, further comprising means for adjusting intensity of input light to said light-receiving surface so as to produce an illumination range in which said photodetector has an effective amplification function.

# FIG. 1

FIG. 2

FIG. 3

hν

2b    3b        3a    2a

1

ℓ

FIG. 4

2b                    2a

1

4b        4a